# EUROPÄISCHE PATENTSCHRIFT

(11) **EP 0 625 402 B1**
(45) Veröffentlichungstag und Bekanntmachung des Hinweises auf die Patenterteilung: **04.06.1997**
(21) Anmeldenummer: 94102130.5
(22) Anmeldetag: 11.02.1994
(51) Int. Cl.: B23K 35/02

(54) **Lotsuspension zum Aufbringen dünner Lotschichten auf Unterlagen**
Suspension for coating substrates with thin solder layers
Suspension pour appliquer des couches minces de soudure sur des substrats

(30) Priorität: 10.05.1993 DE 4315475
(43) Veröffentlichungstag der Anmeldung: 23.11.1994
(73) Patentinhaber: Degussa Aktiengesellschaft, 60311 Frankfurt (DE)
(72) Erfinder: Koschlig, Manfred, Dr. (Ing.), D-63743 Aschaffenburg (DE); Weber, Wolfgang (Chemotechn.), D-63791 Karlstein (DE); Zimmermann, Klaus, Dr. (Dipl.-Chem.), D-63755 Alzenau (DE)

(56) Entgegenhaltungen:
- EP-A- 0 005 068
- DE-C- 4 131 871
- US-A- 3 971 501
- US-A- 4 231 815
- US-A- 4 509 994

## Beschreibung

Die Erfindung betrifft eine Lotsuspension zum Aufbringen dünner Lotschichten auf Unterlagen, bestehend aus 30 bis 90 Gew.% Lotpulver, 0,1 bis 20 Gew.% eines organischen Bindemittels, 1 bis 50 Gew.% eines organischen Lösungsmittels und 0 bis 10 Gew.% eines Flussmittels.

Zum Verbinden von Teilen, deren Verbindungsstelle eine komplexe Geometrie aufweist, verwendet man in der Löttechnik meist Lotpasten, bestehend aus Lotpulver, Bindemittel, Lösungsmittel und Flußmittel. Diese Pasten besitzen eine definierte Viskosität, die es erlaubt, eine automatische Verarbeitung mittels Dosierautomaten vorzunehmen. Die Dosierautomaten bringen jeweils eine bestimmte Menge der zähen Lotpaste an einer bestimmten Stelle der zu verbindenden Teile auf. Der Pastenfleck bleibt durch seine Viskosität an der Stelle, an der er aufgebracht wurde und ändert seine Form nur noch geringfügig. Hat die Lötstelle eine besonders komplizierte Geometrie, kann die Lotpaste auch von Hand aufgetragen werden, z.B. mit einem Pinsel oder einer Spachtel. Diese Verfahrensweisen haben den Nachteil, daß die Maschinen zum automatischen Aufbringen von Lotpasten sehr teuer und auch sehr reparaturanfällig sind. Die Viskosität der Lotpasten führt oft zu Verstopfung der Dosiereinrichtung des Automaten, so daß erhebliche Störungen im Verfahrensablauf in Kauf genommen werden müssen. Das Aufbringen der Lotpaste mit einem Pinsel erfordert Handarbeit und ist deshalb für die Fertigung von großen Stückzahlen unwirtschaftlich. Die Paste kann durch ihre hohe Viskosität bei Verarbeitung mit dem Pinsel nicht sehr gleichmäßig aufgetragen werden. In der Regel wird mit einem Flußmittelzusatz in der Lotpaste gearbeitet, der beim Lötprozeß eine gleichmäßige Verteilung des Lotes in der Verbindungsstelle sicherstellen soll. Mit diesen Techniken ist aber in der Regel keine vollständige Benetzung der Verbindungsstelle zu erreichen, was sich beim fertigen Bauteil z.B. durch Festigkeitseinbußen oder einen schlechten Wärmeübergang auswirkt.

Um diese Schwierigkeiten zu umgehen, lag es nahe, Lotsuspensionen herzustellen, bestehend aus Lotpulver, organischem Bindemittel, größeren Mengen organischer Lösungmitteln und gegebenenfalls Flussmitteln, um dünne Lotschichten beispielsweise durch Tauchen oder Spritzen auf die Verbindungsstellen der Teile aufzubringen. So wird beispielsweise in der DE-PS 41 31 871 ein Verfahren zum Aufbringen von Hartstoffschichten aus metallischen Unterlagen beschrieben, bei dem Hartstoffteilchen und Lotpulver mit 0,1 bis 20 Gew.% eines organischen Bindemittels- und 1 bis 50 Gew.% eines organischen Lösungsmittels zu einer Suspension verarbeitet und auf Unterlagen in Schichtdicken zwischen 10 und 500 µm aufgebracht wird. Die Pulverteilchen haben dabei mittlere Korngrößen von weniger als 20 µm. Hier war es allerdings nicht notwendig, gleichmäßige Lotschichten herzustellen, die keine Risse und Poren aufweisen. Solche Risse und Poren in der Lotschicht erhält man jedoch, wenn man Lotsuspensionen nach der DE-PS 41 31 871 verwendet, die keine Hartstoffe enthalten.

Es war daher Aufgabe der vorliegenden Erfindung, eine Lotsuspension zum Aufbringen dünner Lotschichten auf Unterlagen zu entwickeln, bestehend aus 30 bis 90 Gew.% Lotpulver, 0,1 bis 20 Gew.% eines organischen Bindemittels, 1 bis 50 Gew.% eines organischen Lösungsmittels und 0 bis 10 Gew.% eines Flußmittels, wobei das Lotpulver eine Teilchengröße von 5 bis 50 µm aufweist, und das Verhältnis zwischen mittlerer Teilchengröße des Lotpulvers, gemessen in µm, und der Dichte des Lotpulvers, gemessen in ·g cm⁻³, zwischen 0,1 und 20 liegt, die durch Eintauchen oder Aufspritzen in dünnen, gleichmäßigen, festhaftenden Schichten aufgebracht werden kann und beim Trocknen keine Risse und Poren in der Lotschicht ausbildet.

Diese Aufgabe wird erfindungsgemäß die Merkmale des Anspruchs 1 durch gelöst.

Vorzugsweise liegt die Teilchengröße zwischen 5 und 30 µm, wobei 60 bis 65 % der Teilchen kleiner sind als die Teilchengröße im Maximum der Teilchengrößeverteilungskurve. Vorteilhafterweise liegt das Verhältnis zwischen mittlerer Teilchengröße des Lotpulvers und der Dichte der Lotpulver bei Nickel- und Kupferloten zwischen 0,5 und 5 [µm·g⁻¹·cm³], bei Aluminiumloten zwischen 2 und 17 [µm·g⁻¹·cm³].

Es hat sich herausgestellt, daß man homogene Lot schichten, frei von Rissen und Poren, auf Unterlagen aus Lotsuspensionen erzeugen kann, wenn mehr kleinere Lotpulverteilchen vorliegen als größere Partikel. Die Teilchengrößenverteilungskurve darf also nicht symmetrisch zum Maximum der Teilchengröße verlaufen, sondern asymmetrisch.

Man erhält auf diese Weise Lotsuspensionen, die beispielsweise durch Tauchen oder Spritzen und einen sich daran anschließenden Trockenvorgang eine nicht ablaufende, riß- und porenfreie Beschichtung auf den Unterlagen erzeugt. Es ist dabei von besonderer Bedeutung, daß die Beschichtung in ihrem Zustand direkt nach dem Trocknen, also vor dem eigentlichen Lötprozeß bereits eine absolute gleichmäßige Verteilung der Lotteilchen in der Bindermatrix aufweist, da diese beim Lötprozeß nur durch große Lotüberschüsse, die bei den meisten Fügeverfahren jedoch unerwünscht sind, ausgefüllt werden könnten.

Die erhaltene Lotsuspension ist je nach eingestellter Viskosität (Binder/Lösungsmittel-Verhältnis) für die Verarbeitung durch Eintauchen von Teilen oder die Verarbeitung in einer Preßluftspritzpistole (Lackierspritze) geeignet. Die auf die Unterlagen aufgebrachte Suspension zeigt aufgrund ihrer definierten Zusammensetzung nur geringe Neigung zur Tropfenbildung und zum Ablaufen, so daß Schichten definierter Dicke aufgebracht werden können. Nach dem Aufbringen der Schichten werden die Teile in einem Ofen getrocknet und anschließend gelötet. Beim Lötprozeß muß je nach Schichtstärke zum Ausbrennen des Binders für wenige Minuten bei Ausbrenntemperatur gehalten werden. Bei Schichtstärken <20 µm (nach dem Trocknen) kann auf diesen Ausbrennschritt verzichtet werden. Für Schichtdicken zwischen 20 und 100 µm empfehlen sich Ausbrenndauern von 10 bis 15 Minuten (Temperatur je nach verwendetem Bindersystem zwischen 300° C und 500°C). Dies ist wichtig für eine vollständige Benetzung und eine fehlerfreie Lotschicht ohne Risse und Poren. Es können so Lötverbindungen mit vollflächiger Benetzung auch an Verbindungsstellen mit komplexer Geometrie erzeugt werden. Um stabile Lotsuspensionen zu erhalten muß das Verhältnis zwischen der durchschnittlichen Korngröße des Pulvers [in µm] und der Dichte des Materials [in g/cm³] in einem Bereich zwischen 0,1 und 20 liegen, wobei je nach Lotmaterial differenziert werden muß. So liegt der ideale Bereich z.B. für Kupfer- und Nickel-Lote zwischen 5 und 0,5 und für Aluminium-Lote zwischen 17 und 2. Wird dieser Bereich nicht eingehalten, neigen entweder die Pulverteilchen in der Suspension zum Absetzen, oder es muß bei zu feinem Pulver zu viel Binder zugegeben werden, was sich beim Lötprozeß durch Ungleichmäßigkeiten in der Schicht bemerkbar macht. Bei Bedarf kann noch ein Flußmittelpulver zugegeben werden.

Das Bindersystem besteht aus einem polymeren organischen Bindemittel, z.B. aus der Klasse der Polyacrylate, Polybutene, Polystyrole oder Zellulosederivate, und einem organischen Lösungsmittel, z.B. aus der Klasse der Kohlenwasserstoffe, Glykolether, Glykolester, Alkohole und Ketone mit Verdunstungszahlen zwischen 10 und 10000. Gegebenenfalls, z.B. bei der Verwendung von Aluminium-Lot, wird ein Flußmittel zugegeben. Ein zu schnelles Absetzen des Lotpulvers in der Suspension kann zusätzlich durch den Zusatz rheologischer Additive verhindert werden. Durch die Variation der Zugabe an organischem Binder und organischem Lösungsmittel kann die Viskosität der Suspension so eingestellt werden, daß Lotschichten von 10 bis 500 µm durch Tauchen oder Spritzen aufgebracht werden können. Es werden vorzugsweise kinematische Viskositäten im Bereich von 0,1 bis 1,5 Pas bei einem Schergefälle von D=200 s⁻¹ eingestellt. Die Suspensionen enthalten dabei 0,1 bis 20 % des organischen Binders und 1 bis 50 % des organischen Lösungsmittels. Das Aufbringen kann so gezielt und sparsam erfolgen, daß insbesondere bei der Verwendung von Nickelloten durch Lotaustritt an unerwünschten Stellen beim Löten keine Sprödphasen gebildet werden. Nach dem Aufbringen der Lotschicht werden die beschichteten Teile in einem Trockenschrank, bei einer Temperatur zwischen 50 und 150° C, vorzugsweise bei ca. 110° C getrocknet. Dem eigentlichen Lötprozeß wird ein Temperaturschritt vorgeschaltet, wobei bei einer Temperatur, die abhängig vom benutzten Bindersystem ist, der Binder ausgebrannt wird.

Dieser Temperaturschritt wird bei 300 bis 650° C durchgeführt. vorzugsweise bei 500° C.

Für die Verbindung von Keramikteilen oder Keramik mit Metall sowie die Metallisierung von Keramik sind diese Lotsuspensionen ebenfalls geeignet. In die Suspension aus Lotpulver und Binder wird in einer Dispergierapparatur ein Aktivator (Titan- oder Zirkonium-Pulver) in der erforderlichen Menge gegeben (etwa 10 %) und die Suspension gemischt. Die Viskosität der Suspension wird dabei so eingestellt, daß sie entweder zum Tauchen von Teilen oder zur Verarbeitung durch Spritzen geeignet ist.

Folgende Beispiele sollen die Erfindung näher erläutern:
1. 400 g eines Nickellotes (89 Ni, 11% P ) werden in einer Kugelmühle auf eine mittlere Korngrösse von 8 µm vermahlen. Das Maximum der Teilchengrößenverteilungskurve lag bei 15 µm, rund 65 % der Teilchen waren kleiner als 15 µm. Das Pulver wird mit einer Mischung von 5,5 g Polyisobutylen und 87 g Leichtbenzin in einem Dispergierapparat zu einer homogenen Suspension mit einer kinematischen Viskosität von 0,9 Pas (D=200 s⁻¹ ) verarbeitet, mit der durch einmaliges Tauchen eine Schicht von ca. 70 µm Dicke aufgebracht werden kann. Nach dem Trocknen war diese Lotschicht völlig frei von Rissen und Poren. Die Dichte des verwendeten Lotes betrug 8,13 g/cm³, so daß das Verhältnis zwischen mittlerer Teilchengröße und Dichte des Lotpulvers bei 1,85 µm·g ⁻¹·cm³ lag.
2. 400 g eines Kupferlotes (94 % Cn 6 % P ) wird zu einem Pulver vermahlen, das eine mittlere Teilchengröße von 20 µm aufweist, mit einem Maximum der Teilchengrößenverteilungskurve bei 28 µm. Rund 60 % der Teilchen waren kleiner als 28 µm. Danach werden 40 g Titanpulver (mittlere Teilchengröße 5 µm) zugesetzt und in einer Dispergiereinrichtung mit 5,5 g Polyisobutylen und 94 g Leichtbenzin ca. 30 min miteinander vermischt. Man erhält eine Suspension, die mit einer Druckluftspritzpistole (Düsendurchmesser 1,2 mm) in dünner Schicht auf Teile aufgespritzt werden kann. Die eingestellte kinematische Viskosität beträgt 0,3 Pas (D=200 s⁻¹). Die erhaltene rißfreie Schicht von ca. 20 µm Dicke kann als Metallisierung einer Keramik, zur Verbindung Keramik-Keramik oder Keramik-Metall dienen, speziell wenn die Verbindungsstelle eine komplexe Geometrie aufweist.
   Das Lotpulver besaß eine Dichte von 8,1 g/cm³. Das Verhältnis zwischen mittlerer Teilchengröße und Lotpulverdichte betrug daher 2,47 µm·g⁻¹·cm³.
3. 200 g eines Aluminiumlotes (88 % Al 12 % Si ) wird auf eine mittlere Teilchengröße von 20 µm vermahlen. Das Maximum der Teilchenverteilungskurve lag bei 32 µm, rund 70 % der Teilchen waren kleiner als 32 µm. Dieses Lotpulver wird mit 200 g Flußmittelpulver, 18 g Polyisobutylen und 330 g Leichtbenzin in einem Dispergator homogenisiert. Die erhaltene Suspension der kinematischen Viskosität von 0,6 Pas (D=200 s⁻¹) kann zum Tauchen von Teilen verwendet werden. Die Schichtdicken auf den getauchten Teilen betragen ca. 200 µm. Diese Technik kann z.B. bei der Verbindung von Heizleitern aus Aluminium mit Wasserdurchlaufrohren in Durchlauferhitzern angewendet werden. Die Dichte des Lotpulvers betrug 2,65 g/cm³, das Verhältnis mittlere Teilchengröße zu Dichte 7,55 µm·g⁻¹·cm³.
4. 400 g eines Kupferlotes (87 % Cu, 10 % Mn, 3 % Co ) werden auf eine mittlere Teilchengröße von 10 µm vermahlen, mit einem Maximum der Teilchengrößenverteilungskurve bei 18 µm. Rund 62 % der Lotteilchen waren kleiner als 18 µm. Dieses Pulver wird mit 33 g Polyacrylat und 100 g Xylol in einer Dispergiereinrichtung miteinander vermischt. Nach ca. 20 Minuten ist eine Suspension entstanden, durch die eingetauchte Teileamit einer Schicht von ca. 50 µm Dicke beschichtet werden können, die nach aem Trocknen weder Risse noch Poren aufweist.
   Die Dichte des Lotpulvers betrug 8,8 g/cm³, das Verhältnis mittlere Teilchengröße zu Dichte 2,05 µm·g⁻¹·cm³.

## Patentansprüche

1. Lotsuspension zum Aufbringen dünner Lotschichten auf Unterlagen, bestehend aus 30 bis 90 Gew.% Lotpulver, 0,1 bis 20 Gew.% eines organischen Bindemittels, 1 bis 50 Gew.% eines organischen Lösungsmittels und 0 bis 10 Gew.% eines Flußmittels, wobei das Lotpulver eine Teilchengröße von 5 bis 50 µm aufweist, und das Verhältnis zwischen mittlerer Teilchengröße des Lotpulvers, gemessen in µm, und der Dichte des Lotpulvers, gemessen in g/cm³, zwischen 0,1 und 20 liegt,
**dadurch gekennzeichnet,**
daß das Lotpulver eine Teilchengrößenverteilung besitzt, bei der 55 bis 70 % der Teilchen kleiner sind als die Teilchengröße im Maximum der Teilchengrößenverteilungskurve.

2. Lotsuspension nach Anspruch 1,
**dadurch gekennzeichnet**,
daß die Teilchengröße zwischen 5 und 30 µm liegt, wobei 60 bis 65 % der Teilchen kleiner sind als die Teilchengröße im Maximum der Teilchengrößenverteilungskurve.

3. Lotsuspension nach Anspruch 1 oder 2,
**dadurch gekennzeichnet**,
daß das Verhältnis zwischen mittlerer Teilchengröße des Lotpulvers und der Dichte des Lotpulvers bei Nickel- und Kupferloten zwischen 0,1 und 5 [µm·g⁻¹·cm³] und bei Aluminiumloten zwischen 2 und 17 [µm·g⁻¹·cm³] liegt.

4. Lotsuspension nach einer der vorhergehenden Ansprüche,
**dadurch gekennzeichnet**,
daß die Lotsuspension zusätzlich Titan- oder Zirkoniumpulver enthält.

## Claims

1. Soldering suspension for applying thin layers of solder to substrates, consisting of from 30 to 90 wt.% of soldering powder, from 0.1 to 20 wt.% of an organic binder, from 1 to 50 wt.% of an organic solvent and from 0 to 10 wt.% of a fluxing agent, wherein the soldering powder has a particle size of from 5 to 50 µm and the ratio of the average particle size of the soldering powder, measured in µm, to the density of the soldering powder, measured in g/cm³, is between 0.1 and 20,
characterised in that the soldering powder has a particle-size distribution wherein 55 to 70% of the particles are smaller than the particle size at the maximum of the particle-size distribution curve.

2. Soldering suspension according to claim 1,
characterised in that the particle size is between 5 and 30 µm, 60 to 65% of the particles being smaller than the particle size at the maximum of the particle-size distribution curve.

3. Soldering suspension according to claim 1 or 2,
characterised in that the ratio of the average particle size of the soldering powder to the density of the soldering powder in the case of nickel solders and copper solders is between 0.1 and 5 [µm·g⁻¹·cm³] and in the case of aluminium solders is between 2 and 17 [µm·g⁻¹·cm³].

4. Soldering suspension according to one of the preceding claims,
characterised in that the soldering suspension contains in addition titanium powder or zirconium powder.

## Revendications

1. Suspension de soudure en vue de l'application de couches minces de soudure sur des substrats qui consiste en 30 à 90 % en poids de soudure en poudre, 0,1 à 20 % en poids d'un agent liant organique, 1 à 50 % en poids d'un solvant organique et de 0 à 10 % en poids d'un agent fondant, dans laquelle la soudure en poudre présente une taille de particules allant de 5 à 50 µm, et le rapport entre la taille moyenne des particules de la soudure en poudre, mesurée en µm, et la densité de la soudure en poudre mesurée en g/cm³ se situe entre 0,1 et 20,
caractérisée en ce que
la soudure en poudre possède une distribution de tailles de particules, dans laquelle de 55 à 70 % des particules sont plus petites que la taille des particules au maximum de la courbe de distribution de tailles de particules.

2. Suspension de soudure selon la revendication 1,
caractérisée en ce que
la taille de particules se situe entre 5 et 30 µm, tandis que de 60 à 65 % des particules sont plus petites que la taille des particules au maximum de la courbe de distribution de tailles de particules.

3. Suspension de soudure selon la revendication 1 ou la revendication 2,
caractérisée en ce que
le rapport entre la taille moyenne de particules de la soudure en poudre et la densité de la soudure en poudre pour les soudures au nickel et au cuivre, se situe entre 0,1 et 5 (µm.g⁻¹.cm³) et pour les soudures à l'aluminium entre 2 et 17 (µm.g⁻¹.cm³).

4. Suspension de soudure selon l'une des revendications précédentes,
caractérisée en ce que
la suspension de soudure contient en supplément du titane ou du zirconium en poudre.
